(19) Europäisches Patentamt
European Patent Office
Office européen des brevets

(11) **EP 2 697 661 B1**

(12) **EUROPÄISCHE PATENTSCHRIFT**

(45) Veröffentlichungstag und Bekanntmachung des Hinweises auf die Patenterteilung:
**18.03.2015 Patentblatt 2015/12**

(21) Anmeldenummer: **12716334.3**

(22) Anmeldetag: **12.04.2012**

(51) Int Cl.:
*G01R 31/08* (2006.01)    *H02H 3/33* (2006.01)
*G01R 31/14* (2006.01)    *G01R 31/40* (2014.01)
*G01R 27/18* (2006.01)    *G01R 31/02* (2006.01)
*G01R 31/42* (2006.01)    *H02M 7/44* (2006.01)

(86) Internationale Anmeldenummer:
**PCT/EP2012/056705**

(87) Internationale Veröffentlichungsnummer:
**WO 2012/140153 (18.10.2012 Gazette 2012/42)**

(54) **VERFAHREN UND VORRICHTUNG ZUR BESTIMMUNG EINES FEHLERSTROMANTEILS AN EINEM DIFFERENZSTROM**

METHOD AND APPARATUS FOR DETERMINING A FAULT CURRENT PORTION IN A DIFFERENTIAL CURRENT

PROCÉDÉ ET DISPOSITIF DE DÉTERMINATION D'UNE COMPOSANTE DE COURANT DE DÉFAUT À UN COURANT DIFFÉRENTIEL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.04.2011 DE 102011002084**

(43) Veröffentlichungstag der Anmeldung:
**19.02.2014 Patentblatt 2014/08**

(73) Patentinhaber: **SMA Solar Technology AG**
**34266 Niestetal (DE)**

(72) Erfinder:
• **NUSS, Alexander**
 **34128 Kassel (DE)**
• **BODE, Christian**
 **37434 Rollshausen (DE)**
• **GROOTE, Wilfried**
 **34246 Vellmar (DE)**

(74) Vertreter: **REHBERG HÜPPE + PARTNER**
**Patentanwälte PartG mbB**
**Robert-Gernhardt-Platz 1**
**37073 Göttingen (DE)**

(56) Entgegenhaltungen:
**EP-A1- 2 372 857      EP-A2- 1 229 629**
**WO-A1-2005/050229    DE-A1- 10 215 019**
**DE-A1- 10 253 864    DE-A1- 19 826 410**
**DE-A1- 19 937 061    GB-A- 2 258 095**

• **BLAABJERG F ET AL: "Power electronics - key technology for renewable energy systems", POWER ELECTRONICS, DRIVE SYSTEMS AND TECHNOLOGIES CONFERENCE (PEDSTC), 2011 2ND, IEEE, 16. Februar 2011 (2011-02-16), Seiten 445-466, XP031936654, DOI: 10.1109/PEDSTC. 2011.5742462 ISBN: 978-1-61284-422-0**

**Beschreibung**

## TECHNISCHES GEBIET DER ERFINDUNG

Die Erfindung bezieht sich auf ein Verfahren zur Bestimmung eines Fehlerstromanteils an einem Differenzstrom, der an einem Wechselrichter gemessen wird, wobei das Verfahren die Merkmale des Oberbegriffs des unabhängigen Patentanspruchs 1 aufweist, sowie auf eine Vorrichtung zur Durchführung eines solchen Verfahrens mit den Merkmalen des Oberbegriffs des nebengeordneten Patentanspruchs 9.

Bei dem Wechselrichter handelt es sich insbesondere um einen solchen, der einen von einer Gleichstromquelle bereitgestellten Gleichstrom in einen Wechselstrom umrichtet. Bei dieser Gleichstromquelle kann es sich insbesondere um eine Photovoltaikanlage handeln, die allein aufgrund ihrer räumlichen Ausdehnung eine nicht unerhebliche Ableitkapazität nach Erde aufweist. Aus dieser Ableitkapazität und aus Potentialverschiebungen gegenüber Erde, die im Betrieb des Wechselrichters auftreten, resultieren Ableitströme nach Erde. Diese Ableitströme finden sich in einem Differenzstrom wieder, der regelmäßig zum schnellen Erkennen eines Auftretens von Fehlerströmen überwacht wird. Große Ableitströme führen so dazu, dass die Empfindlichkeit bei der Erkennung von Fehlerströmen durch Überwachung des Differenzstroms reduziert ist. Daher ist es von Interesse, den eigentlichen Fehlerstromanteil des Differenzstroms zu bestimmen.

## STAND DER TECHNIK

Die Normen VDE 0126 und VDE 0126-1-1 fordern, dass sich ein Wechselrichter in Abhängigkeit des Effektivwerts eines plötzlich auftretenden Differenzstroms über seine Netzanschlüsse binnen vorgegebener Abschaltzeiten vom Netz trennt. Wie bereits angesprochen wurde, setzt sich dieser Differenzstrom aus einem resistiven Fehlerstrom und einem zusätzlichen kapazitiven Ableitstrom zusammen, die sich vektoriell zu dem Differenzstrom aufaddieren. Den Vorgaben des normativen Prüfaufbaus und Prüfablaufs zur Erfüllung der genannten Normen ist zu entnehmen, dass allein ein sprunghafter Anstieg des Fehlerstroms - auch bei vorhandenem großem Ableitstrom - zur Trennung des Wechselrichters vom Netz führen muss. Dazu ist es erforderlich, den Fehlerstromanteil an dem Differenzstrom zu bestimmen.

An einem Wechselrichter wird der Differenzstrom üblicherweise mit einem Summenstromwandler gemessen, dessen Spannungssignal ein Maß für den Differenzstrom zwischen den Phasen und dem Nullleiter des Wechselrichters ist. Durch den Trend, trafolose Wechselrichter mit steigenden Leistungen und größeren Abmessungen der Photovoltaikanlagen zu entwickeln, erhöhen sich die Kapazitäten gegenüber Erde und damit die auftretenden Ableitströme. Durch Verwendung bestimmter Materialien für die Photovoltaikanlagen verstärkt sich diese Tendenz weiter. Zudem sind die Ableitkapazitäten beispielsweise bei einer Photovoltaikanlage als Gleichstromquelle nicht konstant, sondern ändern sich unter anderem durch Niederschlag auf die Photovoltaikpaneele. Zur ausreichend empfindlichen Erfassung eines Sprungs im Fehlerstrom muss daher der Ableitstromanteil fortlaufend von dem Differenzstrom abgetrennt werden.

Zur Separierung von Ableitströmen von dem Spannungssignal eines Summenstromwandlers ist es bekannt, alle sich langsam ändernden Ströme, die der Summenstromwandler misst, als Ableitströme zu definieren und durch eine Auswertungssoftware zu kompensieren. Auftretende Sprünge des Fehlerstroms können dann vektoriell berechnet werden. Bei dieser Vorgehensweise werden jedoch Sprünge im Ableitstrom falsch als Fehlerströme interpretiert.

Aus der WO 98/58432 A1 sind ein Verfahren und eine Einrichtung zur Isolations- und Fehlerstromüberwachung in einem elektrischen Wechselstromnetz bekannt. Bei diesen wird der durch vektorielle Addition gebildete Differenzstrom zwischen den Netzleitern erfasst. Von dem Differenzstrom wird ein Wechselstromanteil bestimmt. Als zweite Netzgröße wird die Netzwechselspannung zwischen zumindest zwei Netzleitern oder zwischen einem Netzleiter und einem Potentialausgleichsleiter oder einem Neutralleiter erfasst. Dann wird als Maß für den resistiven Fehlerstrom des Netzes das Produkt zwischen der Amplitude des Wechselstromanteils des Differenzstroms und dem Kosinus des Phasenwinkels $\phi$ zwischen den beiden erfassten Netzgrößen ermittelt. Diese Ermittlung kann durch eine Multiplikation des Wechselstromanteils des Differenzstroms mit einem Multiplikationssignal und eine anschließende arithmetische Mittelwertbildung durchgeführt werden, wobei das Multiplikationssignal der bezüglich ihres Effektivwerts konstant gehaltenen Netzwechselspannung entspricht. Bei der Ausweitung dieses bekannten Verfahrens auf ein mehrphasiges Wechselstromnetz sollen die genannten Schritte für jeden der drei Netzleiter getrennt durchgeführt werden, indem der Wechselstromanteil des Differenzstroms aller drei Netzleiter erfasst wird, indem ferner die drei Netzwechselspannungen zwischen jedem Netzleiter sowie einem Neutralleiter oder einem Potentialausgleichsleiter erfasst werden und indem die entsprechenden drei Produkte zwischen der Amplitude des Wechselstromanteils des Differenzstroms sowie den Kosinuswerten der drei Phasenwinkel $\phi$ ermittelt werden. Während das offenbarte Verfahren grundsätzlich auf einen einphasigen Wechselrichter anwendbar ist, stellt sich jedoch heraus, dass der Wechselfehlerstromanteil an einem Differenzstrom, der an einem mehrphasigen Wechselrichter gemessen wird, auf diese Weise nicht zutreffend bestimmbar ist. Auch bei einem einphasigen Wechselrichter treten Betriebszustände auf, in denen der Wechselfehlerstromanteil an dem gemessenen Differenzstrom mit dem bekannten Verfahren nicht zutreffend bestimmt wird.

## AUFGABE DER ERFINDUNG

Der Erfindung liegt die Aufgabe zugrunde, ein Verfahren zur Bestimmung eines Fehlerstromanteils an einem Differenzstrom, der an einem Wechselrichter gemessen wird, sowie eine Vorrichtung zur Durchführung eines solchen Verfahrens aufzuzeigen, mit denen zumindest der Wechselfehlerstromanteil und vorzugsweise auch der Gesamtfehlerstromanteil an dem Differenzstrom zutreffend bestimmt werden.

## LÖSUNG

Die Aufgabe der Erfindung wird durch ein Verfahren mit den Merkmalen des unabhängigen Patentanspruchs 1 und eine Vorrichtung mit den Merkmalen des nebengeordneten Patentanspruchs 9 gelöst. Bevorzugte Ausführungsformen des neuen Verfahrens sind in den abhängigen Patentansprüchen 2 bis 8 definiert. Die abhängigen Patentansprüche 10 bis 14 betreffen bevorzugte Ausführungsformen der neuen Vorrichtung. Der Patentanspruch 15 ist auf einen Wechselrichter mit der Vorrichtung nach einem der vorangehenden Vorrichtungsansprüche gerichtet.

## BESCHREIBUNG DER ERFINDUNG

Bei dem erfindungsgemäßen Verfahren zur Bestimmung eines Fehlerstromanteils an einem Differenzstrom, der an einem Wechselrichter gemessen wird, wird zur Bestimmung eines Wechselfehlerstromanteils an dem Differenzstrom (i) eine an einem Wechselstromausgang des Wechselrichters anliegende Wechselspannung erfasst; (ii) in Abhängigkeit von der erfassten Wechselspannung eine periodische Referenzfunktion wechselnden Vorzeichens generiert; (iii) der Differenzstrom mit der Referenzfunktion multipliziert; und (iv) das Produkt aus dem Differenzstrom und der Referenzfunktion über eine ganze Zahl von Perioden der Referenzfunktion gemittelt wird. Dabei wird die Referenzfunktion zumindest für einen Betriebszustand des Wechselrichters mit einem vorgegebenen Phasenversatz zu der erfassten Wechselspannung und/oder mit einer Frequenz generiert, die ein ganzzahliges Vielfaches der Frequenz der erfassten Wechselspannung ($u_{AC}(t)$) ist. D. h., zumindest für den einen Betriebszustand des Wechselrichters weicht die Referenzfunktion in ihrer Phase und/oder in ihrer Frequenz definiert von der erfassten Wechselspannung ab.

Die vorliegende Erfindung beruht auf der Erkenntnis, dass es für die Bestimmung eines Fehlerstromanteils an dem an einem Wechselrichter gemessenen Differenzstrom nicht ausreicht, Potentialschwankungen mit der Frequenz und Phase von an einem oder mehreren Ausgängen erfassten Wechselspannungen auf der Gleichstromseite des Wechselrichters anzunehmen. Zumindest gilt dies für bestimmte Betriebszustände nahezu aller Wechselrichter und für alle Betriebszustände mehrphasiger Wechselrichter. Um die relevanten Potentialschwankungen auf der Gleichstromseite des Wechselrichters korrekt zu antizipieren, wird zwar auch bei dem erfindungsgemäßen Verfahren eine Referenzfunktion basierend auf der an einem Ausgang des Wechselrichters erfassten Wechselspannung generiert. Diese Referenzfunktion weist aber zumindest für bestimmte Betriebszustände des Wechselrichters einen vorgegebenen Phasenversatz und insbesondere für viele Betriebszustände von mehrphasigen Wechselrichtern eine Frequenz auf, die ein kleines ganzzahliges Vielfaches ungleich 1 der einzelnen Wechselspannungen an den Wechselstromausgängen ist.

Die Betriebszustände, in denen der vorgegebene Phasenversatz zur Anwendung kommt, sind typischerweise solche, in denen Halbleiterschalter mit antiparallelen Dioden einer Wechselrichterbrücke des Wechselrichters nicht angesteuert werden, die Wechselrichterbrücke die Gleichstromseite des Wechselrichters also ausschließlich passiv über die antiparallelen Dioden mit allen Ausgängen des Wechselrichters verbindet, an denen Wechselspannungen anliegen. Hierbei tritt ein typischer Phasenversatz der resultierenden Potentialschwankungen auf der Gleichstromseite des Wechselrichters gegenüber einer oder mehreren Wechselspannungen auf, die an dem bzw. den Ausgängen des Wechselrichters anliegen. Dieser Phasenversatz ist durch den Betriebszustand des Wechselrichters vorgegeben und kann auf theoretische Weise ermittelt werden. Der Phasenversatz kann auch so bestimmt werden, dass durch Variation des Phasenversatzes der Referenzfunktion gegenüber der erfassten Wechselspannung bei Durchführung des erfindungsgemäßen Verfahrens an einem definitiv fehlerfreien Wechselrichter der Wechselfehlerstromanteil minimiert wird. Der so ermittelte Phasenversatz kann dann für diesen Betriebszustand zukünftig fest vorgegeben werden.

In dem bereits angesprochenen Betriebszustand, in dem Halbleiterschalter mit antiparallelen Dioden einer Wechselrichterbrücke des Wechselrichters nicht angesteuert werden, kann auch bei einem einphasigen Wechselrichter die dominante Potentialschwankung auf der Gleichstromseite des Wechselrichters in ihrer Frequenz gegenüber der Frequenz der an einem Ausgang erfassten Wechselspannung zum Beispiel auf das Doppelte erhöht sein. Zudem stellt sich schon im Normalbetrieb vieler mehrphasiger Wechselrichter heraus, dass auf ihrer Gleichstromseite Potentialschwankungen auftreten, die nicht die Frequenz der einzelnen Wechselspannungen an den Wechselstromausgängen des Wechselrichters aufweisen, sondern eine Frequenz, die in einem größeren ganzzahligen Verhältnis als 1 zur Frequenz der einzelnen Wechselspannungen an den Wechselstromausgängen steht. Insbesondere bei dreiphasigen Wechselrichtern treten auf der Gleichstromseite regelmäßig Potentialschwankungen von der dreifachen Frequenz der einzelnen Wechselspannungen an den Wechselstromausgängen auf, die - zum Beispiel bei einem Isolationsfehler - resistive Ströme nach Erde hervorrufen, welche sich in dem gemessenen Differenzstrom wiederfinden. Entsprechend beträgt dann die Frequenz des relevanten Wechselfehlerstromanteils das Dreifache der Frequenz der einzelnen Wechselspannungen an den Wechselstromausgängen. Die somit in einem konkreten Anwendungsfall anzusetzende Frequenz der Referenzfunktion kann auf theoretische Weise aus den Eigenschaften der Wechselspannungen an den Wechselstromausgängen oder auch durch Auswertung der regelmäßig vorhandenen Differenzströme ermittelt werden. Bei einem einphasigen Wechselrichter kann die Frequenz der relevanten Potentialschwankungen auf seiner Gleichstromseite neben dem Einfachen der Frequenz der Wechselspannung an seinem Wechselstromausgang, in bestimmten Betriebszuständen auch das Doppelte dieser Frequenz betragen. Bei einem zweiphasigen Wechselrichter, insbesondere einem solchen der an ein Split-Phase-Netz nach US-Norm angeschlossen ist, kann die Frequenz der relevanten Potentialschwankungen auf seiner Gleichstromseite neben dem Einfachen der Frequenz der Wechselspannungen an seinen Wechselstromausgängen bereits im Normalbetrieb auch das Doppelte dieser Frequenz betragen. So zeigen sich häufig Potentialschwankungen auf der Gleichstromseite, deren Frequenz bei einem n-phasigen Wechselrichter das n-fache der Frequenz der Wechselspannungen an seinen Wechselstromausgängen beträgt. Manchmal sind auch Potentialschwankungen auf der Gleichstromseite eines n-phasigen Wechselrichters relevant, deren Frequenz das 2n-fache und/oder das 3n-fache der Frequenz der Wechselspannungen an seinen Wechselstromausgängen beträgt

Im Normalbetrieb, in dem Halbleiterschalter mit antiparallelen Dioden einer Wechselrichterbrücke des Wechselrichters angesteuert werden, um beispielsweise durch Pulsweitenmodulation die von dem Wechselrichter abgegebenen Wechselströme sinusförmig zu formen, sind die Potentialschwankungen auf der Gleichstromseite des Wechselrichters typischerweise mit der Gesamtheit der Wechselspannungen an den Ausgängen des Wechselrichters in Phase, so dass in diesem Betriebszustand die Referenzfunktion bei dem erfindungsgemäßen Verfahren so generiert wird, dass Nulldurchgänge der Referenzfunktion mit Nulldurchgängen der erfassten Wechselspannung zusammenfallen. Wenn die Referenzfunktion dabei eine höhere Frequenz als die Wechselspannung aufweist, weist sie auch noch zusätzliche Nulldurchgänge auf, die dann typischerweise mit Nulldurchgängen anderer Wechselspannungen an anderen Ausgängen des Wechselrichters zusammenfallen.

Indem der Differenzstrom mit einer Referenzfunktion multipliziert wird, die in Phase mit den antizipierten Potentialschwankungen schwingt, und anschließend über eine Periode oder eine ganze Anzahl von Perioden dieser Referenzfunktion gemittelt wird, wird der von den antizipierten Potentialschwankungen hervorgerufene Wechselfehlerstromanteil aus dem Differenzstrom heraus selektiert und insbesondere von kapazitiven Ableitströmen und jedweden Gleichstromanteilen an dem Differenzstrom separiert. Alle kapazitiven Ableitströme, die durch dieselben Potentialschwankungen hervorgerufen werden, weisen einen Phasenversatz von 90° oder $\pi/2$ zu den Potentialschwankungen auf, so dass ihr Produkt mit der Referenzfunktion im zeitlichen Mittel 0 ist. Auch das Produkt aller Gleichstromanteile an dem Differenzstrom und der Referenzfunktion ist durch deren Vorzeichenwechsel 0.

Bei dem erfindungsgemäßen Verfahren kann zur Bestimmung eines weiteren Wechselfehlerstromanteils an dem Differenzstrom der Differenzstrom mit mindestens einer weiteren periodischen Referenzfunktion wechselnden Vorzeichens multipliziert werden, die eine Frequenz aufweist, deren Frequenz zu der Frequenz der Referenzfunktion in einem ganzzahligen Verhältnis steht, wobei Nulldurchgänge der weiteren Referenzfunktion mit Nulldurchgängen der Referenzfunktion zusammenfallen, und das Produkt aus dem Differenzstrom und der weiteren Referenzfunktion über eine ganze Zahl von Perioden der weiteren Referenzfunktion gemittelt werden. Wenn die Frequenz der weiteren Referenzfunktion 2-mal so groß wie die Frequenz der Referenzfunktion, berücksichtigt dieser weitere Wechselfehlerstromanteil eine häufig wesentliche erste Oberwelle eines Gesamtwechselfehlerstromanteils an dem Differenzstrom. So treten auf der Eingangsseite des Wechselrichters insbesondere Potentialschwankungen mit einer doppelten Frequenz der Potentialschwankungen über der Gesamtheit der Wechselspannungen an den Wechselstromausgängen des Wechselrichters auf. Hiervon hervorgerufene resistive Wechselströme werden durch den weiteren Wechselfehlerstromanteil, der unter Verwendung der frequenzverdoppelten Referenzfunktion bestimmt wird, abgebildet. Grundsätzlich kann die Frequenz der weiteren Referenzfunktion auch niedriger als diejenige der Referenzfunktion sein, zum Beispiel wenn die Referenzfunktion selbst bereits Potentialschwankungen mit einer mehrfachen Frequenz der Potentialschwankungen über der Gesamtheit der Wechselspannungen an den Wechselstromausgängen des Wechselrichters abbildet.

Um aus einzelnen Wechselfehlerstromanteilen einen Gesamtwechselfehlerstromanteil an dem Differenzstrom zu bestimmen, sind die einzelnen Wechselfehlerstromanteile unterschiedlicher Frequenzen geometrisch zu addieren.

Alternativ zur tatsächlichen Bestimmung verschiedener Wellenanteilen können bei gegebenen Randbedingungen (Wechselrichtertyp, PV-Leistung u.ä.) deren relative Amplituden auch abgeschätzt werden, indem der mit der Referenzfunktion für die dominierende Welle ermittelte Wechselfehlerstromanteil mit einem Skalierungsfaktor multipliziert wird, um einen Näherungswert für den Gesamtwechselfehlerstromanteil zu ermitteln. Sofern zumindest eine Messung des Wechselfehlerstromanteils von zwei Wellen, beispielsweise der Grund- und einer Oberwelle, vorliegt, kann dieser Skalierungsfaktor aus deren relativer Amplitude überprüft und ggf. modifiziert werden.

Vorzugsweise ist die Referenzfunktion entsprechend dem typischen zeitlichen Verlauf der Potentialschwankungen auf der Gleichstromseite des Wechselrichters bei sinusförmigen Wechselspannungen an seinen Wechselstromausgängen eine Sinusfunktion. Die Nulldurchgänge der Sinusfunktion werden vorzugsweise mit den Nulldurchgängen der erfassten Wechselspannungen getriggert. Dabei löst jeder Nulldurchgang ohne oder mit dem definierten Phasenversatz einen Nulldurchgang der Sinusfunktion aus. Dazu werden bei dem erfindungsgemäßen Verfahren zumindest die Zeitpunkte dieser Nulldurchgänge bei der Wechselspannung erfasst, die an einem Ausgang des Wechselrichters anliegt. Auch wenn die Nulldurchgänge der Sinusfunktion nur mit den Nulldurchgängen einer von mehreren Wechselspannungen an mehreren Ausgängen des Wechselrichters getriggert werden, stehen sie zu den Nulldurchgängen aller gleichmäßig phasenversetzten Wechselspannungen in einer definierten Phasenbeziehung.

Wenn die Referenzfunktion einen Scheitelwert von $\sqrt{2}$ aufweist, ist der Mittelwert des Produkts aus dem Differenzstrom und der Referenzfunktion unmittelbar der Effektivwert des von den Potentialschwankungen mit der Frequenz der Referenzfunktion auf der Gleichstromseite des Wechselrichters hervorgerufenen Wechselfehlerstromanteils an dem Differenzstrom.

Die Mittelwertbildung für die Bestimmung jedes Wechselfehlerstromanteils an dem Differenzstrom erfolgt bei dem erfindungsgemäßen Verfahren vorzugsweise über eine ganze Zahl von Perioden der an dem Wechselstromausgang des Wechselrichters erfassten Wechselspannung. Hierdurch deckt der Mittelwert jedwede Asymmetrien zwischen mehreren Wechselspannungen an den Wechselstromausgängen des Wechselrichters ab bzw. wird von diesen nicht beeinflusst. Eine oben im Zusammenhang mit verschiedenen Wechselfehlerstromanteilen angesprochene geometrische Addition ist auch erforderlich, um einen Gesamtfehlerstromanteil an dem Differenzstrom zu bestimmen, der neben dem Gesamtwechselfehlerstromanteil einen Gleichfehlerstromanteil umfasst. Dieser Gleichfehlerstromanteil an dem Differenzstrom selbst kann durch einfache zeitliche Mittlung des Differenzstroms ermittelt werden.

Bei dem neuen Verfahren können alle Wechselstromausgänge des Wechselrichters, einschließlich eines etwaigen Nullleiters, von einer an den Wechselrichter angeschlossenen Wechselstromlast oder einem angeschlossenen Wechselstromnetz getrennt werden und/oder kann der Wechselrichter abgeschaltet werden, wenn der Wechselfehlerstromanteil oder der Gleichfehlerstromanteil oder der Gesamtfehlerstromanteil an dem Differenzstrom einen Stromgrenzwert für eine Mindestzeit überschreitet. Dabei können die Stromgrenzwerte und die zugehörigen Mindestzeiten den eingangs genannten Normen entsprechen.

Der Differenzstrom kann bei dem erfindungsgemäßen Verfahren an dem Wechselrichter zwischen allen Wechselstromausgängen des Wechselrichters gemessen werden. Grundsätzlich ist aber auch eine Messung des Differenzstroms über die Eingangsleitungen des Wechselrichters möglich. Um die Referenzfunktion jedoch bezüglich ihrer Phase auf die Nulldurchgänge der Wechselspannungen abzustimmen, muss bei dem erfindungsgemäßen Verfahren zumindest eine der Wechselspannungen an einem Wechselstromausgang des Wechselrichters erfasst werden.

Eine erfindungsgemäße Vorrichtung zur Durchführung des erfindungsgemäßen Verfahrens umfasst (i) einen Summenstromwandler zum Messen eines Differenzstroms an einem Wechselrichter; (ii) eine Einrichtung zum Erfassen einer an einem Wechselstromausgang des Wechselrichters anliegenden Wechselspannung; (iii) einen Signalgenerator zum Generieren einer periodischen Referenzfunktion wechselnden Vorzeichens in Abhängigkeit von der erfassten Wechselspannung; (iv) einen Multiplikationsknoten zum Multiplizieren des Differenzstroms mit der Referenzfunktion; und (iv) einen Mittelwertbildner zum Bilden eines Mittelwerts des Produkts des Multiplikationsknotens über eine ganze Zahl von Perioden der Referenzfunktion. Der Signalgenerator ist dabei so ausgebildet, dass er die Referenzfunktion zumindest für einen Betriebszustand des Wechselrichters mit einem vorgegebenen Phasenversatz zu der erfassten Wechselspannung und/oder mit einer Frequenz generiert wird, die einganzzahliges Vielfaches der Frequenz der erfassten Wechselspannung ist.

Konkret kann der Signalgenerator ein Sinusgenerator sein und mit den Nulldurchgängen der an dem Wechselstromausgang des Wechselrichters erfassten Wechselspannungen getriggert werden.

Die Vorrichtung kann weiterhin einen A/D-Wandler für den Differenzstrom und die erfasste Wechselspannung aufweisen. Dann sind die weiteren Bestandteile der Vorrichtung digital ausgebildet, einschließlich des Signalgenerators.

Um auch mindestens eine weitere Welle der Potentialschwankungen auf der Gleichstromseite des Wechselrichters zu berücksichtigen, kann die Vorrichtung einen weiteren Multiplikationsknoten und einen weiteren Mittelwertbildner aufweisen, um den Differenzstrom zum Beispiel mit einer gegenüber der Referenzfunktion frequenzverdoppelten weiteren Referenzfunktion zu multiplizieren und um über eine ganze Zahl von Perioden der weiteren Referenzfunktion einen Mittelwert des Produkts des weiteren Multiplikationsknotens zu bilden. Grundsätzlich können bei der neuen Vorrichtung wie bei dem neuen Verfahren auch noch weitere, höher- oder tieferfrequente Wellen Berücksichtigung finden. Hierfür ist dann entsprechend der Differenzstrom mit weiteren Referenzfunktionen zu multiplizieren.

Die gemittelten Produkte der einzelnen Multiplikationsknoten werden bei der neuen Vorrichtung in einem Addierer geometrisch addiert. Ein solcher geometrischer Addierer kann auch für die zusätzliche Addition des von einem Mittelwertbildner gebildeten zeitlichen Mittelwerts des Differenzstroms vorgesehen sein.

Jeder der Mittelwertbildner kann zum Beispiel als Integrator mit einer passend eingestimmten Integrationszeit, aber auch als Tiefpassfilter mit einer ausreichend tief abgestimmten Abschneidefrequenz ausgebildet sein. Bei digitaler Ausbildung des Mittelwertbildners kann dieser auch tatsächlich einen Mittelwert über eine Anzahl von Einzelwerten des jeweiligen Produkts ausbilden, die einer vorgegebenen Anzahl von Perioden des Referenzsignals entsprechen.

Bei einem erfindungsgemäßen Wechselrichter mit einer Steuerung und einer erfindungsgemäßen Vorrichtung zur Bestimmung des Fehlerstromanteils an einem an dem Wechselrichter gemessene Differenzstrom trennt die Steuerung zumindest alle Wechselstromausgänge des Wechselrichters an denen im normalen fehlerfreien Betrieb des Wechselrichters eine Wechselspannung anliegt, von einer Wechselstromlast oder einem Wechselstromnetz und/oder schaltet den Wechselrichter ab, wenn das gemittelte Produkt eines Multiplikationsknotens oder der gemittelte Differenzstrom oder ein Ausgangssignal eines geometrischen Addierers einen Grenzwert für eine Mindestzeit überschreitet. Ein vorhandener Nullleiter kann ebenfalls abgetrennt werden. Die von den eingangs genannten Normen vorgegebenen Grenzwerte von 30/60/150 mA, die für Zeiträume von 300/150/40 ms nicht überschritten werden dürfen, sind erfindungsgemäß leicht zu überwachen, da auch eine Mindestzeit von 40 ms bei einem 50 Hz Wechselstrom noch zwei Perioden des Wechselstroms umfasst und entsprechend bei Mittelwertbildung über eine Periode des Wechselstroms ein auftretender Fehlerstrom sehr zeitnah (ohne Berücksichtung der Signallaufzeiten binnen 20 ms) voll erfasst wird.

Vorteilhafte Weiterbildungen der Erfindung ergeben sich aus den Patentansprüchen, der Beschreibung und den Zeichnungen. Die in der Beschreibungseinleitung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Weitere Merkmale sind den Zeichnungen - insbesondere den dargestellten Anordnungen und Wirkverbindungen - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

## KURZBESCHREIBUNG DER FIGUREN

Die Erfindung wird im Folgenden anhand von Ausführungsbeispielen unter Bezugnahme auf die beigefügten Zeichnungen näher erläutert und beschrieben.

Fig. 1    zeigt einen Wechselrichter mit einer erfindungsgemäßen Vorrichtung zur Durchführung des erfindungsgemäßen Verfahrens.

Fig. 2    zeigt ein Blockdiagramm zur Durchführung des erfindungsgemäßen Verfahrens; und

Fig. 3    zeigt den zeitlichen Verlauf von Wechselspannungen an Wechselstromausgängen des Wechselrichters gemäß Fig. 1, eines an dem Wechselrichter gemessenen Differenzstroms und einer bei dem erfindungsgemäßen Verfahren eingesetzten Referenzfunktion.

## FIGURENBESCHREIBUNG

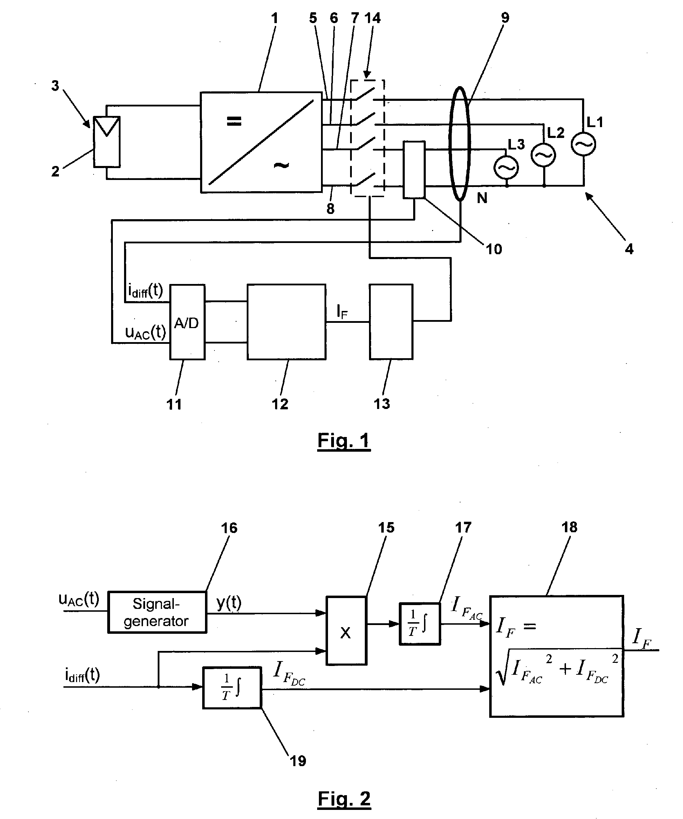

In **Fig. 1** ist ein Wechselrichter 1 gezeigt, der eingangsseitig an eine Photovoltaikanlage 2 als Gleichstromquelle 3 angeschlossen ist. Ausgangsseitig ist der Wechselrichter an ein dreiphasiges Wechselstromnetz 4 angeschlossen. Er weist dazu Wechselstromausgänge 5 bis 8 auf. Dabei sind die Wechselstromausgänge 5 bis 7 für Außenleiter L1 bis L3 und der Wechselstromausgang 8 für den Nullleiter N des dreiphasigen Wechselstromnetzes 4 vorgesehen. Entsprechend liegen an den Wechselstromausgängen 5 bis 7 die drei phasenversetzte Wechselspannungen $u_{AC}(t)$ des Wechselstromnetzes 4 an. Ein Summenstromwandler 9 ist zum Erfassen des Differenzstroms $i_{diff}(t)$ zwischen allen Wechselstromausgängen 5 bis 8 des Wechselrichters 1 vorgesehen. Eine Messeinrichtung 10 erfasst eine der drei Wechselspannungen $u_{AC}(t)$ an der Ausgangsleitung 7 gegenüber dem Nullpotential an dem Wechselstromanschluss 8. Der Differenzstrom $i_{diff}(t)$ und die Wechselspannung $u_{AC}(t)$ werden in einem A/D-Wandler 11 digitalisiert und dann einer Auswertungseinrichtung 12 zugeführt, die aus den hier zugeführten Werten einen Fehlerstrom $I_F$ bestimmt. Dieser Fehlerstrom wird in einer Bewertungseinrichtung 13 mit Grenzwerten verglichen, und für den Fall des Überschreitens eines der Grenzwerte für einen dem jeweiligen Grenzwert zugeordneten Zeitraum wird ein Trennschalter 14 betätigt, um den Wechselrichter 1 allphasig von dem Wechselstromnetz 4 zu trennen. Die aus dem Summenstromwandler 9, der Messeinrichtung 10, dem A/D-Wandler 11, der Auswerteeinrichtung 12 und der Beurteilungseinrichtung 13 gebildete Vorrichtung 9 bis 13 misst also den Differenzstrom $i_{diff}(t)$ an dem Wechselrichter 1, bestimmt daraus den Fehlerstrom $I_F$ und trennt beim Überschreiten von Grenzwerten für den Fehlerstrom den Wechselrichter 1 vom Netz und kann ihn zusätzlich abschalten.

Das Blockdiagramm gemäß **Fig. 2** zeigt die Schritte, die in der Auswerteeinrichtung 12 durchgeführt werden, um aus dem gemessenen Differenzstrom $i_{diff}(t)$ den Fehlerstrom $I_F$ zu bestimmen. Aus dem Differenzstrom $i_{diff}(t)$ wird einmal ein Gleichfehlerstromanteil $I_{FDC}$ ermittelt, indem in einem Mittelwertbildner 19 ein Mittelwert des Differenzstrom $i_{diff}(t)$ gebildet wird, was durch Integration über einen Zeitraum und anschließende Division durch den Zeitraum angedeutet ist. Zusätzlich wird der Fehlerstrom $i_{diff}(t)$ in einem Multiplizierknoten 15 mit einer periodischen Referenzfunktion $y(t)$ mit wechselndem Vorzeichen multipliziert, die von einem Signalgenerator 16 generiert wird, dem die Wechselspannung $u_{AC}(t)$ zugeführt wird. Der Signalgenerator 16 generiert die Referenzfunktion $y(t)$ als Sinusfunktion, deren Frequenz bei der in Fig. 1 dargestellten Konfiguration z.B. der dreifachen Frequenz der Wechselspannung $u_{AC}(t)$ entspricht, wobei jeder Nulldurchgang der Wechselspannung $u_{AC}(t)$ einen Nulldurchgang der Referenzfunktion $y(t)$ triggert. Je nach Betriebszustand des Wechselrichters werden die Nulldurchgänge der Referenzfunktion $y(t)$ zusätzlich um einen vorgegebenen, zum Beispiel einen vorab ermittelten Phasenversatz verzögert. Da die drei Wechselspannungen des Wechselrichters 1 gemäß Fig. 1 gleiche Phasenversätze zueinander aufweisen, bedeutet dies, dass die Referenzfunktion $y(t)$ bei jedem Nulldurchgang jeder der Wechselspannungen an den Wechselstromausgängen 5 bis 7 des Wechselrichters 1 ebenfalls einen Nulldurchgang aufweist. Die Referenzfunktion $y(t)$ bildet die Grundwelle der Potentialschwankungen auf der Gleichstromeingangsseite des Wechselrichters 1 gemäß Fig. 1 ab, und durch ihre Multiplikation mit dem Differenzstrom $i_{diff}(t)$ in dem Multiplizierknoten 15 und eine anschließende Mittelwertbildung in einem Mittelwertbildner 17 wird der resistive Wechselfehlerstromanteil $I_{FAC}$ des Differenzstroms $i_{diff}(t)$ bestimmt, der mit diesen Potentialschwankungen in Phase ist. Abschließend werden der Gleichfehlerstromanteil $I_{FDC}$ und der Wechselfehlerstromanteil $I_{FAC}$ in einem geometrischen Addierer 18 quadratisch addiert, um den Fehlerstromanteil $I_F$ zu erhalten.

Der gemessene Differenzstrom $i_{diff}(t)$ kann inklusive aller Oberwellenanteile durch folgende Summe aus Fourierreihen beschrieben werden:

$$i_{Diff}(t) = a_0 + \sum_{k=1}^{\infty} a_k \sin(k\omega_0 t) + \sum_{k=1}^{\infty} b_k \cos(k\omega_0 t) \qquad \text{(I)}$$

Dabei entspricht der Summand $a_0$ dem Gleichstromanteil des Differenzstroms, der zweite Summand dem Gesamtwechselfehlerstromanteil einschließlich aller Oberwellenanteile und der dritte Summand dem kapazitiven Ableitstromanteil, der ebenfalls ein Wechselstromanteil ist, aber zu dem resistiven Gesamtwechselfehlerstromanteil eine Phasenverschiebung von 90° aufweist.

Multiplikation mit der Sinusfunktion $y(t) = \sqrt{2} \cdot \sin(\omega_0 t)$, d. h. der Referenzfunktion $y(t)$ mit dem Scheitelwert oder der Amplitude $\sqrt{2}$, ergibt:

$$i_{Diff}(t) \cdot \sqrt{2} \cdot \sin(\omega_0 t) = a_0 \sqrt{2} \cdot \sin(\omega_0 t) + \sum_{k=1}^{\infty} \sqrt{2} \cdot a_k \sin(k\omega_0 t) \cdot \sin(\omega_0 t) + \sum_{k=1}^{\infty} \sqrt{2} \cdot b_k \cos(k\omega_0 t) \cdot \sin(\omega_0 t) \qquad \text{(II)}$$

Anschließende Mittelwertbildung über die Periodendauer $T$ ergibt:

$$\frac{1}{T}\int_0^T i_{Diff}(t) \cdot \sqrt{2} \cdot \sin(\omega_0 t)dt = \frac{1}{T}\int_o^T a_0 \sqrt{2} \cdot \sin(\omega_0 t)dt + \frac{1}{T}\int_o^T \sum_{k=1}^{\infty} \sqrt{2} \cdot a_k \sin(k\omega_0 t) \cdot \sin(\omega_0 t)dt$$

$$+ \frac{1}{T}\int_o^T \sum_{k=1}^{\infty} \sqrt{2} \cdot b_k \cos(k\omega_0 t) \cdot \sin(\omega_0 t)dt \qquad \text{(III)}$$

Für die Summanden auf der rechten Seite der Gleichung III gilt:

$$\frac{1}{T}\int_o^T a_0 \sqrt{2}\cdot\sin(\omega_0 t)dt = 0$$

$$\frac{1}{T}\int_o^T \sum_{k=1}^{\infty}\sqrt{2}\cdot a_k \sin(k\omega_0 t)\cdot\sin(\omega_0 t)dt = 0\big|k\neq 1$$

$$\frac{1}{T}\int_o^T \sum_{k=1}^{\infty}\sqrt{2}\cdot a_k \sin(k\omega_0 t)\cdot\sin(\omega_0 t)dt = \frac{1}{\sqrt{2}}\cdot a_1\big|k = 1$$

$$\frac{1}{T}\int_o^T \sum_{k=1}^{\infty}\sqrt{2}\cdot b_k \cos(k\omega_0 t)\cdot\sin(\omega_0 t)dt = 0 \qquad (IV)$$

Da alle Summanden bis auf den Fehlerstromanteil der Grundwelle (k=1) gleich null sind, folgt:

$$\left|\frac{1}{T}\int_0^T i_{Diff}(t)\cdot\sqrt{2}\cdot\sin(\omega_0 t)dt\right| = \left|\frac{1}{\sqrt{2}}\cdot a_1\right| = \left|\sqrt{\frac{1}{T}\int_0^T (a_1\cdot\sin(\omega_0 t))^2\, dt}\right| = I_{Fac} \qquad (V)$$

Nach der Multiplikation des gemessenen Differenzstroms $i_{diff}(t)$ mit der Referenzfunktion y(t) und der Mittelwertbildung ergibt sich also der Effektivwert des Fehlerwechselstromanteils des Differenzstroms $i_{diff}(t)$ bei der Frequenz der Grundwelle.

Für die Berechnung der Oberwellenanteile des Wechselfehlerstromanteils an dem Differenzstrom kann analog verfahren werden, in dem die Frequenz des Referenzsignals y(t) entsprechend der betrachteten Ordnung der Oberwelle mit ganzzahligen Werten (k>1) multipliziert wird.

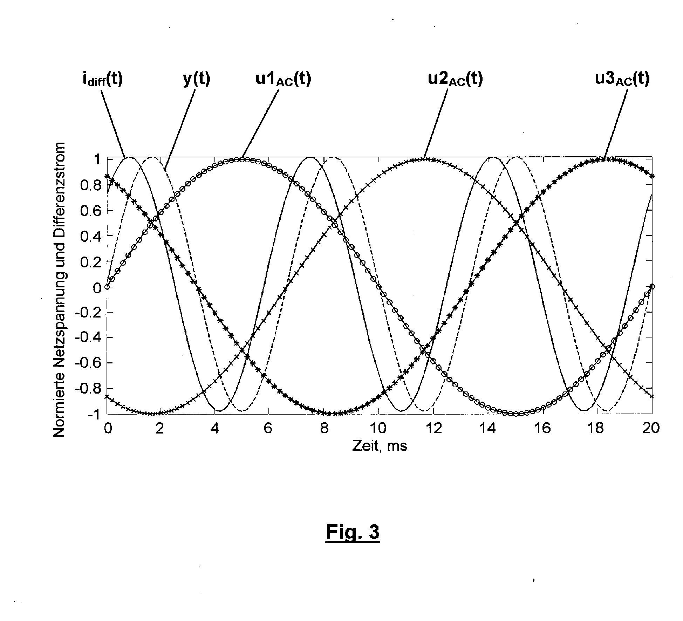

**Fig. 3** zeigt den zeitlichen Verlauf der drei Wechselspannungen $u1_{AC}(t)$ bis $u3_{AC}(t)$, des Differenzstroms $i_{diff}(t)$ und der im Normalbetrieb des Wechselrichters zu verwendenden Referenzfunktion y(t), die wie die Wechselspannungen $u1_{AC}(t)$ bis $u3_{AC}(t)$ eine Sinusfunktion ist und die bei jedem Nulldurchgang einer der drei Wechselspannungen $u1_{AC}(t)$ bis $u3_{AC}(t)$ ihrerseits einen Nulldurchgang aufweist. Da die Frequenz der Referenzspannung y(t) genau dreimal so groß ist wie diejenige der einzelnen Wechselspannungen $u_{AC}(t)$, weist sie keine weiteren Nulldurchgänge auf. Zur Erfassung eines ersten Oberwellenanteils des Differenzstroms $i_{diff}(t)$ wäre eine gegenüber der Referenzfunktion y(t) frequenzverdoppelte Referenzfunktion zu verwenden und mit dem Differenzstroms $i_{diff}(t)$ zu multiplizieren.

**BEZUGSZEICHENLISTE**

| | |
|---|---|
| 1 | Wechselrichter |
| 2 | Photovoltaikanlage |
| 3 | Gleichstromquelle |
| 4 | Wechselstromnetz |
| 5 | Wechselstromanschluss |
| 6 | Wechselstromanschluss |
| 7 | Wechselstromanschluss |
| 8 | Wechselstromausgang |
| 9 | Summenstromwandler |
| 10 | Messeinrichtung |
| 11 | A/D-Wandler |
| 12 | Auswerteeinrichtung |
| 13 | Beurteilungseinrichtung |
| 14 | Trennschalter |
| 15 | Multiplizierknoten |
| 16 | Signalgenerator |

| 17 | Mittelwertbildner |
|----|----|
| 18 | Addierer |
| 19 | Mittelwertbildner |
| 9-13 | Vorrichtung |
| L1 | Außenleiter |
| L2 | Außenleiter |
| L3 | Außenleiter |
| N | Nullleiter |
| $i_{diff}(t)$ | Differenzstrom |
| $u_{AC}(t)$ | Wechselspannung |
| $I_F$ | Gesamtfehlerstromanteil |
| $y(t)$ | Referenzfunktion |
| $I_{FDC}$ | Gleichfehlerstromanteil |
| $I_{FAC}$ | Wechselfehlerstromanteil |
| T | Periode |

**Patentansprüche**

1. Verfahren zur Bestimmung eines Fehlerstromanteils ($I_F$) an einem Differenzstrom ($i_{diff}(t)$), der an einem Wechselrichter (1) gemessen wird, wobei zur Bestimmung eines Wechselfehlerstromanteils *($I_{FAC}$)* an dem Differenzstrom ($i_{diff}(t)$)

   - eine an einem Wechselstromausgang des Wechselrichters (1) anliegende Wechselspannung ($u_{AC}(t)$) erfasst wird;
   - in Abhängigkeit von der erfassten Wechselspannung ($u_{AC}(t)$) eine periodische Referenzfunktion ($y(t)$) wechselnden Vorzeichens generiert wird;
   - der Differenzstrom ($i_{diff}(t)$) mit der Referenzfunktion ($y(t)$) multipliziert wird; und
   - das Produkt aus dem Differenzstrom ($i_{diff}(t)$) und der Referenzfunktion ($y(t)$) über eine ganze Zahl von Perioden (*T*) der Referenzfunktion ($y(t)$) gemittelt wird;

   **dadurch gekennzeichnet, dass** die Referenzfunktion ($y(t)$) zumindest für einen Betriebszustand des Wechselrichters (1) mit einem vorgegebenen Phasenversatz zu der erfassten Wechselspannung ($u_{AC}(t)$) und/oder mit einer Frequenz generiert wird, die ein ganzzahliges Vielfaches der Frequenz der erfassten Wechselspannung ($u_{AC}(t)$) ist.

2. Verfahren nach Anspruch 1, **dadurch gekennzeichnet, dass** die Referenzfunktion ($y(t)$) zumindest für einen Betriebszustand des Wechselrichters (1), in dem Halbleiterschalter mit antiparallelen Dioden einer Wechselrichterbrücke des Wechselrichters (1) nicht angesteuert werden, mit dem vorgegebenen Phasenversatz zu der Wechselspannung ($u_{AC}(t)$) generiert wird.

3. Verfahren nach Anspruch 1 oder 2, **dadurch gekennzeichnet, dass** der Wechselrichter (1) n Wechselstromausgänge aufweist, an denen n Wechselspannungen ($u_{AC}(t)$) gleicher Frequenz anliegen, wobei n größer als 1 ist, und dass die Referenzfunktion ($y(t)$) mit einer Frequenz generiert wird, die mindestens n-mal so groß ist wie die Frequenz der erfassten Wechselspannung ($u_{AC}(t)$).

4. Verfahren nach einem der vorhergehenden Ansprüche, **dadurch gekennzeichnet, dass** die Referenzfunktion ($y(t)$) zumindest für einen Betriebszustand des Wechselrichters (1), in dem Halbleiterschalter mit antiparallelen Dioden einer Wechselrichterbrücke des Wechselrichters (1) angesteuert werden, so generiert wird, dass Nulldurchgänge der Referenzfunktion ($y(t)$) mit Nulldurchgängen der erfassten Wechselspannung ($u_{AC}(t)$) zusammenfallen, und/oder dass die Referenzfunktion ($y(t)$) eine Sinusfunktion ist, deren Nulldurchgänge mit den Nulldurchgängen der erfassten Wechselspannung ($u_{AC}(t)$) getriggert werden.

5. Verfahren nach einem der vorhergehenden Ansprüche, **dadurch gekennzeichnet, dass** zur Bestimmung eines weiteren Wechselfehlerstromanteils an dem Differenzstrom ($i_{diff}(t)$)

   - eine weitere periodische Referenzfunktion wechselnden Vorzeichens generiert wird, deren Frequenz zu der Frequenz der Referenzfunktion ($y(t)$) in einem ganzzahligen Verhältnis steht, wobei Nulldurchgänge der weiteren Referenzfunktion ($y(t)$) mit Nulldurchgängen der Referenzfunktion zusammenfallen,

- der Differenzstrom ($i_{diff}(t)$) mit der weiteren Referenzfunktion multipliziert wird und
- das Produkt aus dem Differenzstrom ($i_{diff}(t)$) und der weiteren Referenzfunktion über eine ganze Zahl von Perioden der weiteren Referenzfunktion gemittelt wird.

6. Verfahren nach einem der vorhergehenden Ansprüche, **dadurch gekennzeichnet, dass** das Produkt aus dem Differenzstrom ($i_{diff}(t)$) und jeder Referenzfunktion ($y(t)$) über eine ganze Zahl von Perioden ($T$) der Wechselspannung ($u_{AC}(t)$) gemittelt wird.

7. Verfahren nach einem der vorhergehenden Ansprüche, **dadurch gekennzeichnet, dass** zum Bestimmen eines Gleichfehlerstromanteils ($I_{F_{DC}}$) an dem Differenzstrom ($i_{diff}(t)$) der Differenzstrom ($i_{diff}(t)$) zeitlich gemittelt wird, wobei optional der Gleichfehlerstromanteil ($I_{F_{DC}}$) und jeder Wechselfehlerstromanteil ($I_{F_{AC}}$) geometrisch addiert werden, um einen Gesamtfehlerstromanteil ($I_F$) an dem Differenzstrom ($i_{diff}(t)$) zu bestimmen.

8. Verfahren nach einem der vorhergehenden Ansprüche, **dadurch gekennzeichnet, dass** alle Wechselstromausgänge (5 bis 8) des Wechselrichters (1), an denen Wechselspannungen ($u_{AC}(t)$) anliegen, von einer Wechselstromlast oder einem Wechselstromnetz (4) getrennt werden und/oder der Wechselrichter (1) abgeschaltet wird, wenn der Wechselfehlerstromanteil ($I_{F_{AC}}$) oder der Gleichfehlerstromanteil ($I_{F_{DC}}$) oder der Gesamtfehlerstromanteil ($I_F$) einen Stromgrenzwert für eine Mindestzeit überschreitet.

9. Vorrichtung (9-13) zur Durchführung des Verfahrens nach einem der vorhergehenden Ansprüche,

   - mit einem Summenstromwandler (9) zum Messen eines Differenzstroms ($i_{diff}(t)$) an einem Wechselrichter (1);
   - mit einer Messeinrichtung (10) zum Erfassen einer an einem Wechselstromausgang des Wechselrichters (1) anliegenden Wechselspannung ($u_{AC}(t)$);
   - mit einem Signalgenerator (16) zum Generieren einer periodischen Referenzfunktion ($y(t)$) wechselnden Vorzeichens in Abhängigkeit von der erfassten Wechselspannung ($u_{AC}(t)$);
   - mit einem Multiplikationsknoten (15) zum Multiplizieren des Differenzstroms ($i_{diff}(t)$) mit der Referenzfunktion ($y(t)$); und
   - mit einem Mittelwertbildner (17) zum Bilden eines Mittelwerts des Produkts des Multiplikationsknotens (15) über eine ganze Zahl von Perioden ($T$) der Referenzfunktion ($y(t)$); **dadurch gekennzeichnet, dass** der Signalgenerator (16) die Referenzfunktion ($y(t)$) zumindest für einen Betriebszustand des Wechselrichters (1) mit einem vorgegebenen Phasenversatz zu der erfassten Wechselspannung ($u_{AC}(t)$) und/oder mit einer Frequenz generiert, die ein ganzzahliges Vielfaches der Frequenz der erfassten Wechselspannung ($u_{AC}(t)$) ist.

10. Vorrichtung (9-13) nach Anspruch 9, **dadurch gekennzeichnet, dass** der Wechselrichter (1) n Wechselstromausgänge aufweist, an denen n Wechselspannungen ($u_{AC}(t)$) gleicher Frequenz anliegen, wobei n größer als 1 ist, und dass der Signalgenerator (16) die Referenzfunktion ($y(t)$) mit einer Frequenz generiert, die mindestens n-mal so groß ist wie die Frequenz der erfassten Wechselspannung ($u_{AC}(t)$).

11. Vorrichtung (9-13) nach Anspruch 9 oder 10, **gekennzeichnet durch**

   - einen weiteren Signalgenerator (16) zum Generieren einer weiteren Referenzfunktion ($y(t)$), deren Frequenz zu der Frequenz der Referenzfunktion ($y(t)$) in einem ganzzahligen Verhältnis steht, wobei Nulldurchgänge der weiteren Referenzfunktion ($y(t)$) mit Nulldurchgängen der Referenzfunktion zusammenfallen,
   - einen weiteren Multiplikationsknoten zum Multiplizieren des Differenzstroms ($i_{diff}(t)$) mit der weiteren Referenzfunktion und
   - einen weiteren Mittelwertbildner zum Bilden eines Mittelwerts des Produkts des weiteren Multiplikationsknotens über eine ganze Zahl von Perioden der weiteren Referenzfunktion.

12. Vorrichtung (9-13) nach einem der Ansprüche 9 bis 11, **dadurch gekennzeichnet, dass** der Signalgenerator (16) ein Sinusgenerator ist und mit den Nulldurchgängen der erfassten Wechselspannung ($u_{AC}(t)$) getriggert wird.

13. Vorrichtung (9-13) nach einem der Ansprüche 9 bis 12, **dadurch gekennzeichnet, dass** ein Mittelwertbildner (19) für den Differenzstrom ($i_{diff}(t)$) vorgesehen ist, wobei optional jeder Mittelwertbildner (17, 19) einen Integrator oder Tiefpassfilter aufweist.

14. Vorrichtung (9-13) nach einem der Ansprüche 9 bis 13, **dadurch gekennzeichnet, dass** der Summenstromwandler (9) den Differenzstrom ($i_{diff}(t)$) zwischen allen Wechselstromausgängen (5-8) des Wechselrichters (1) misst und/oder dass ein A/D-Wandler. (11) für den Differenzstrom ($i_{diff}$(t)) und die erfasste Wechselspannung ($u_{AC}$(t)) vorgesehen ist.

**15.** Wechselrichter (1) mit einer Steuerung und einer Vorrichtung (9-13) nach einem der Ansprüche 9 bis 14, **dadurch gekennzeichnet, dass** die Steuerung alle Wechselstromausgänge (5 bis 8) des Wechselrichters (1), an denen Wechselspannungen ($u_{AC}$(t)) anliegen, von einer Wechselstromlast oder einem Wechselstromnetz (4) trennt und/oder den Wechselrichter (1) abschaltet, wenn das gemittelte Produkt eines Multiplikationsknotens (15) oder der gemittelte Differenzstrom ($i_{diff}$(t)) oder ein Ausgangssignal eines geometrischen Addierers (18) einen Grenzwert für eine Mindestzeit überschreitet.

**Claims**

**1.** Method of determining a fault current portion ($I_F$) in a differential current ($i_{diff}$(t)) which is measured at an inverter (1), wherein, for determining an AC fault current portion ($I_{F_{AC}}$) in the differential current ($i_{diff}$(t)),

- an AC voltage ($u_{AC}$(t)) present at an AC current output of the inverter (1) is measured:
- a periodic reference function (y(t)) of alternating sign is generated as a function of the measured AC voltage ($u_{AC}$(t));
- the differential current ($i_{diff}$(t)) is multiplied by the reference function (y(t)); and
- the product of the differential current ($i_{diff}$(t)) and the reference function (y(t)) is averaged over an integral number of periods ($T$) of the reference function (y(t));

**characterized in that** the reference function (y(t)), at least for one operating state of the inverter (1), is generated with a predefined phase offset with respect to the measured AC voltage ($u_{AC}$(t)) and/or at a frequency which is an integral multiple of the frequency of the measured AC voltage ($u_{AC}$(t)).

**2.** Method of claim 1, **characterized in that** the reference function (y(t)), at least for one operating state of the inverter (1) in which semiconductor switches having anti-parallel diodes in an inverter bridge of the inverter (1) are not switched, is generated with the predefined phase offset with respect to the AC voltage ($u_{AC}$(t)).

**3.** Method of claim 1 or 2, **characterized in that** the inverter (1) comprises n AC current outputs at which n AC voltages ($u_{AC}$(t)) of a same frequency are present, wherein n is higher than 1, and that the reference function (y(t)) is generated at a frequency which is at least n times as high as the frequency of the measured AC voltage ($u_{AC}$(t)).

**4.** Method of any of the preceding claims, **characterized in that** the reference function (y(t)), at least for one operating state of inverter (1) in which semiconductor switches having anti-parallel diodes in an inverter bridge of the inverter (1) are switched, is generated in such a way that zero crossings of the reference function (y(t)) coincide with zero crossings of the measured AC voltage ($u_{AC}$(t)), and/or that the reference function (y(t)) is a sine function whose zero crossings are triggered by the zero crossings of the measured AC voltage ($u_{AC}$(t)).

**5.** Method of any of the preceding claims, **characterized in that**, for determining a further AC fault current portion in the differential current ($i_{diff}$(t)),

- a further periodic reference function of alternating sign is generated whose frequency is in an integral ratio to the frequency of the reference function (y(t)), wherein zero crossings of the further reference function (y(t)) coincide with zero crossings of the reference function,
- the differential current ($i_{diff}$(t)) is multiplied by the further reference function, and
- the product of the differential current ($i_{diff}$(t)) and the further reference function is averaged over an integral number of periods of the further reference function.

**6.** Method of any of the preceding claims, **characterized in that** the product of the differential current ($i_{diff}$(t)) and each reference function (y(t)) is averaged over an integral number of periods ($T$) of the AC voltage ($u_{AC}$(t)).

**7.** Method of any of the preceding claims, **characterized in that**, for determining a DC fault current portion ($I_{F_{DC}}$) in the differential current ($i_{diff}$(t)), the differential current ($i_{diff}$(t)) is temporally averaged, wherein, optionally, the DC fault current portion ($I_{F_{DC}}$) and each AC fault current portion ($I_{F_{AC}}$) are geometrically added up to determine a total fault current portion ($I_F$) in the differential current ($i_{diff}$(t)).

8. Method of any of the preceding claims, **characterized in that** all AC current outputs (5 to 8) of the inverter (1) at which AC voltages ($u_{AC}(t)$) are present are separated from an AC load or an AC power grid (4) and/or the inverter (1) is switched off, if the AC fault current portion ($I_{F_{AC}}$) or the DC fault current portion ($I_{F_{DC}}$) or the total fault current portion ($I_F$) exceeds a current threshold value for a minimum period of time.

9. Apparatus (9-13) for executing the method of any of the preceding claims,

   - comprising a summation current transformer (9) for measuring a differential current ($i_{diff}(t)$) at an inverter (1);
   - comprising a measurement device (10) for measuring an AC voltage ($u_{AC}(t)$) present at an AC current output of the inverter (1);
   - comprising a signal generator (16) for generating a periodic reference function ($y(t)$) of alternating sign as a function of the measured AC voltage ($u_{AC}(t)$);
   - comprising a multiplication knot (15) for multiplying the differential current ($i_{diff}(t)$) by the reference function ($y(t)$); and
   - comprising an averager (17) for forming an average value of the product of the multiplication knot (15) over an integral number of periods (*T*) of reference function ($y(t)$); **characterized in that** the signal generator (16), at least for one operating state of the inverter (1), generates the reference function ($y(t)$) with a predefined phase offset with respect to the measured AC voltage ($u_{AC}(t)$) and/or at a frequency which is an integral multiple of the frequency of the measured AC voltage ($u_{AC}(t)$).

10. Apparatus (9-13) of claim 9, **characterized in that** the inverter (1) comprises n AC voltage outputs at which n AC voltages ($u_{AC}(t)$) of a same frequency are present, wherein n is higher than 1, and **in that** the signal generator (16) generates the reference function ($y(t)$) at a frequency which is at least n times as high as the frequency of the measured AC voltage ($u_{AC}(t)$).

11. Apparatus 9-13 of the claim 9 or 10, **characterized by**

   - a further signal generator (16) for generating a further reference function ($y(t)$) whose frequency is in an integral ratio to the frequency of the reference function ($y(t)$), wherein zero crossings of the further reference function ($y(t)$) coincide with zero crossings of the reference function,
   - a further multiplication knot for multiplying the differential current ($i_{diff}(t)$) by the further reference function, and
   - a further averager for forming an average value of the product of the further multiplication knot over an integral number of periods of the further reference function.

12. Apparatus (9-13) of any of the claims 9 to 11, **characterized in that** the signal generator (16) is a sine generator and is triggered by the zero crossings of the measured AC voltage ($u_{AC}(t)$).

13. Apparatus (9-13) of any of the claims 9 to 12, **characterized in that** an averager (19) is provided for the differential current ($i_{diff}(t)$), wherein, optionally each averager (17, 19) comprises an integrator or low pass filter.

14. Apparatus (9-13) of any of the claims 9 to 13, **characterized in that** the summation current transformer (9) measures the differential current ($i_{diff}(t)$) between all AC current outputs (5-8) of the inverter (1), and/or that an A/D converter (11) is provided for the differential current ($i_{diff}(t)$) and the measured AC voltage ($u_{AC}(t)$).

15. Inverter (1) comprising a controller and an apparatus (9-13) of any of the claims 9 to 14, **characterized in that** the controller separates all AC current outputs (5 to 8) of the inverter (1) at which AC voltages ($u_{AC}(t)$) are present from an AC load or an AC power grid (4) and/or switches the inverter (1) off, if the averaged product of a multiplication knot (15) or the averaged differential current ($i_{diff}(t)$) or an output signal of a geometric adder (18) exceeds a threshold value for a minimum period of time.

**Revendications**

1. Procédé de détermination d'une composante de courant de défaut ($I_F$) à un courant différentiel ($i_{diff}(t)$) qui est mesurée au niveau d'un onduleur (1), étant entendu qu'aux fins de la détermination d'une composante de courant de défaut alternatif ($I_{FAC}$) à un courant différentiel ($i_{diff}(t)$):

   - une tension alternative ($u_{AC}(t)$) présente à une sortie de courant alternatif de l'onduleur (1) est détectée;

- en fonction de la tension alternative ($u_{AC}(t)$) détectée, une fonction de référence périodique ($y(t)$) d'un signe alternatif est générée;
- le courant différentiel ($i_{diff}(t)$) est multiplié par la fonction de référence ($y(t)$); et
- le produit du courant différentiel ($i_{diff}(t)$) et de la fonction de référence ($y(t)$) est mis à la moyenne sur un nombre entier de périodes (T) de la fonction de référence ($y(t)$);

**caractérisé en ce que** la fonction de référence ($y(t)$) est générée au moins pour un état de fonctionnement de l'onduleur (1) avec un décalage de phase prédéterminé par rapport à la tension alternative ($u_{AC}(t)$) détectée et/ou avec une fréquence qui est un multiple entier de la fréquence de la tension alternative ($u_{AC}(t)$) détectée.

2. Procédé selon la revendication 1, **caractérisé en ce que** la fonction de référence ($y(t)$) est générée avec le décalage de phase prédéterminé par rapport à la tension alternative ($u_{AC}(t)$) au moins pour un état de fonctionnement de l'onduleur (1) dans lequel des commutateurs à semiconducteurs ne sont pas pilotés avec des diodes antiparallèles d'un pont d'onduleur de l'onduleur (1).

3. Procédé selon la revendication 1 ou 2, **caractérisé en ce que** l'onduleur (1) présente n sorties de courant alternatif auxquelles n tensions alternatives ($u_{AC}(t)$) d'une même fréquence sont présentes, étant entendu que n est supérieur à 1, et **en ce que** la fonction de référence ($y(t)$) est générée à une fréquence qui est au moins n fois plus importante que la fréquence de la tension alternative ($u_{AC}(t)$) détectée.

4. Procédé selon l'une des revendications précédentes, **caractérisé en ce que** la fonction de référence ($y(t)$) est générée au moins pour un état de fonctionnement de l'onduleur (1) dans lequel des commutateurs à semiconducteurs sont pilotés avec des diodes antiparallèles d'un pont d'onduleur de l'onduleur (1) de telle sorte que des passages par zéro de la fonction de référence ($y(t)$) coïncident avec des passages par zéro de la tension alternative ($u_{AC}(t)$) détectée et/ou **en ce que** la fonction de référence ($y(t)$) est une fonction sinusoïdale dont les passages par zéro sont déclenchés avec les passages par zéro de la tension alternative ($u_{AC}(t)$) détectée.

5. Procédé selon l'une des revendications précédentes, **caractérisé en ce qu'**aux fins de la détermination d'une autre composante de courant de défaut alternatif au courant différentiel ($i_{diff}(t)$):

- une autre fonction de référence périodique d'un signe alternatif est générée, dont la fréquence a un rapport d'un nombre entier avec la fréquence de la fonction de référence ($y(t)$), étant entendu que des passages par zéro de l'autre fonction de référence ($y(t)$) coïncident avec des passages par zéro de la fonction de référence;
- le courant différentiel ($i_{diff}(t)$) est multiplié par l'autre fonction de référence; et
- le produit du courant différentiel ($i_{diff}(t)$) et de l'autre fonction de référence est mis à la moyenne sur un nombre entier de périodes de l'autre fonction de référence.

6. Procédé selon l'une des revendications précédentes, **caractérisé en ce que** le produit du courant différentiel ($i_{diff}(t)$) et de la fonction de référence ($y(t)$) est mis à la moyenne sur un nombre entier de périodes (T) de la tension alternative ($u_{AC}(t)$).

7. Procédé selon l'une des revendications précédentes, **caractérisé en ce qu'**aux fins de la détermination d'une composante de courant de défaut continu ($I_{FDC}$) au courant différentiel ($i_{diff}(t)$), le courant différentiel ($i_{diff}(t)$) est mis à la moyenne dans le temps, étant entendu qu'en option, la composante de courant de défaut continu ($I_{FDC}$) et la composante de courant de défaut alternatif ($I_{FAC}$) sont additionnées géométriquement afin de déterminer une composante globale de courant de défaut ($I_F$) au courant différentiel ($i_{diff}(t)$).

8. Procédé selon l'une des revendications précédentes, **caractérisé en ce que** toutes les sorties de courant alternatif (5 à 8) de l'onduleur (1) auxquelles des tensions alternatives ($u_{AC}(t)$) sont présentes sont séparées d'une charge de courant alternatif ou d'un réseau de courant alternatif (4) et/ou l'onduleur (1) est désactivé lorsque la composante de courant de défaut alternatif ($I_{FAC}$) ou la composante de courant de défaut continu ($I_{FDC}$) ou la composante globale de courant de défaut ($I_F$) dépasse une valeur limite de courant pendant une période minimale.

9. Dispositif (9-13) destiné à mettre en oeuvre le procédé selon l'une des revendications précédentes,

- comprenant un transformateur de courant cumulé (9) destiné à mesurer un courant différentiel ($i_{diff}(t)$) au niveau d'un onduleur (1);
- comprenant un dispositif de mesure (10) destiné à détecter une tension alternative ($u_{AC}(t)$) présente au niveau d'une sortie de courant alternatif de l'onduleur (1);

- comprenant un générateur de signaux (16) destiné à générer une fonction de référence périodique (y(t)) d'un signe alternatif en fonction de la tension alternative ($u_{AC}$(t)) détectée;
- comprenant un noeud de multiplication (15) destiné à multiplier le courant différentiel ($i_{diff}$(t)) par la fonction de référence (y(t)); et
- comprenant un formateur de valeurs moyennes (17) destiné à former une valeur moyenne du produit du noeud de multiplication (15) sur un nombre entier de périodes (T) de la fonction de référence (y(t));

**caractérisé en ce que** le générateur de signaux (16) génère la fonction de référence (y(t)) au moins pour un état de fonctionnement de l'onduleur (1) avec un décalage de phase prédéterminé par rapport à la tension alternative ($u_{AC}$(t)) détectée et/ou avec une fréquence qui est un multiple entier de la fréquence de la tension alternative ($u_{AC}$(t)) détectée.

10. Dispositif (9-13) selon la revendication 9, **caractérisé en ce que** l'onduleur (1) présente n sorties de courant alternatif auxquelles n tensions alternatives ($u_{AC}$(t)) d'une même fréquence sont présentes, étant entendu que n est supérieur à 1, et **en ce que** le générateur de signaux (16) génère la fonction de référence (y(t)) à une fréquence qui est au moins n fois plus importante que la fréquence de la tension alternative ($u_{AC}$(t)) détectée.

11. Dispositif (9-13) selon la revendication 9 ou 10, **caractérisé par**:

- un autre générateur de signaux (16) destiné à générer une autre fonction de référence (y(t)) dont la fréquence a un rapport d'un nombre entier avec la fréquence de la fonction de référence (y(t)), étant entendu que des passages par zéro de l'autre fonction de référence (y(t)) coïncident avec des passages par zéro de la fonction de référence;
- un autre noeud de multiplication destiné à multiplier le courant différentiel ($i_{diff}$(t)) par l'autre fonction de référence; et
- un autre formateur de valeurs moyennes destiné à former une valeur moyenne du produit de l'autre noeud de multiplication sur un nombre entier de périodes de l'autre fonction de référence.

12. Dispositif (9-13) selon l'une des revendications 9 à 11, **caractérisé en ce que** le générateur de signaux (16) est un générateur sinusoïdal et il est déclenché avec les passages par zéro de la tension alternative ($u_{AC}$(t)) détectée.

13. Dispositif (9-13) selon l'une des revendications 9 à 12, **caractérisé en ce qu'**un formateur de valeurs moyennes (19) est prévu pour le courant différentiel ($i_{diff}$(t)), étant entendu qu'en option, chaque formateur de valeurs moyennes (17, 19) présente un intégrateur ou un filtre passe-bas.

14. Dispositif (9-13) selon l'une des revendications 9 à 13, **caractérisé en ce que** le transformateur de courant cumulé (9) mesure le courant différentiel ($i_{diff}$(t)) entre toutes les sorties de courant alternatif (5-8) de l'onduleur (1) et/ou **en ce qu'**un convertisseur A/N (11) est prévu pour le courant différentiel ($i_{diff}$(t)) et la tension alternative ($u_{AC}$(t)) détectée.

15. Onduleur (1) comprenant une commande et un dispositif (9-13) selon l'une des revendications 9 à 14, **caractérisé en ce que** la commande sépare toutes les sorties de courant alternatif (5 à 8) de l'onduleur (1) auxquelles des tensions alternatives ($u_{AC}$(t)) sont présentes d'une charge de courant alternatif ou d'un réseau de courant alternatif (4) et/ou désactive l'onduleur (1) lorsque le produit mis à la moyenne d'un noeud de multiplication (15) ou le courant différentiel ($i_{diff}$(t)) ou un signal de sortie d'un additionneur géométrique (18) dépasse une valeur limite pendant une période minimale.

**Fig. 1**

**Fig. 2**

**Fig. 3**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9858432 A1